# EUROPÄISCHE PATENTSCHRIFT

(11) **EP 2 041 044 B1**
(45) Veröffentlichungstag und Bekanntmachung des Hinweises auf die Patenterteilung: **01.09.2010**
(21) Anmeldenummer: 07787509.4
(22) Anmeldetag: 13.07.2007
(51) Int. Cl.: C04B 35/573, H01L 21/02

(54) **VERFAHREN ZUM HERSTELLEN EINES KERAMIKSUBSTRATS SOWIE KERAMIKSUBSTRAT**
METHOD FOR THE PRODUCTION OF A CERAMIC SUBSTRATE, AND A CERAMIC SUBSTRATE
PROCÉDÉ DE FABRICATION D'UN SUBSTRAT CÉRAMIQUE ET SUBSTRAT CÉRAMIQUE

(30) Priorität: 13.07.2006 DE 102006032636
(43) Veröffentlichungstag der Anmeldung: 01.04.2009
(73) Patentinhaber: Schunk Kohlenstofftechnik GmbH, 35452 Heuchelheim (DE)
(72) Erfinder: EBERT, Marco, 35444 Bibertal-Vetzberg (DE); HENRICH, Martin, 35582 Wetzlar (DE); LAUER, Andreas, 35274 Kirchhain (DE); NAUDITT, Gotthard, 35625 Hüttenberg (DE); SCHEIBEL, Thorsten, 61231 Bad Nauheim (DE); WEISS, Roland, 35625 Hüttenberg (DE)
(74) Vertreter: Stoffregen, Hans-Herbert
(86) Internationale Anmeldenummer: PCT/EP2007/057241
(87) Internationale Veröffentlichungsnummer: WO 2008/006900

(56) Entgegenhaltungen:
- EP-A- 1 634 860
- EP-A2- 1 219 578
- WO-A-2005/049524

## Beschreibung

Die Erfindung bezieht sich auf ein Verfahren zur Herstellung eines Keramiksubstrats eines Halbleiterbauelements. Ferner nimmt die Erfindung Bezug auf ein Keramiksubstrat in Form eines Trägers als Bestandteil eines Halbleiterbauelements.

In der Halbleitertechnik wie Solartechnik ist es bekannt, elektrisch aktive Schichten auf ein Substrat wie Graphitsubstrat aufzutragen. Für Solarzellen weisen die entsprechenden Träger Abmessungen üblicherweise von maximal 10 x 10 cm auf, so dass eine aufwendige Verschaltung von entsprechenden Solarzellen zu Panels erforderlich ist.

Aus der DE-A-10 2004 043 985 ist ein Carbidkeramikmaterial und ein Verfahren zur Herstellung eines solchen bekannt. Das Carbidkeramikmaterial weist als Ausgangsmaterial Kohlenstoff-Kurzfasern auf. Das Carbidkeramikmaterial kann dabei als Tragstruktur für einen Siliziumwafer oder einen Objektivträger verwendet werden.

In der Literaturstelle DE.Z.: cfi/Ber. DKG 82 (2005), Nr. 5, D 32 wird berichtet, dass Papier, das mit aus Silizium- und Aluminiummetallpulvem bestehenden Füllstoffen beladen ist, durch Pyrolyse und sich anschließender Oxidation in SiC-Faserkeramikkörper umgewandelt wird. Dabei weist der Körper ein inneres Skelett aus SiC und eine äußere Schicht aus Oxidkeramik auf. Entsprechendes lehrt auch die WO-A-2005/049524.

Der EP-A-1 219 578 ist ein Si/SiC-Verbundwerkstoff zu entnehmen, der als wesentliche Bestandteile Cellulosefasern wie Papierzellstoff aufweist. Zur Herstellung von Reaktorrohren oder Wafer-Schiffchen können Zellulosefasern einer Dicke von 20 µm und einer Länge von 3 mm mit einem Harz imprägniert werden, um sodann verformt, pyrolysiert und siliziert zu werden.

Der vorliegenden Erfindung liegt die Aufgabe zu Grunde, ein Keramiksubstrat sowie ein Verfahren zur Herstellung eines Keramiksubstrats für ein Halbleiterbauelement zur Verfügung zu stellen, das großflächig ausgebildet ist und ein geringes Gewicht aufweist. Gleichzeitig sollte durch das Keramiksubstrat die Möglichkeit eröffnet werden, den Aufbau der auf das Keramiksubstrat aufzubringenden aktiven Schichten zu erleichtern und somit zu einer Kostenreduktion zu führen.

Verfahrensmäßig wird die Aufgabe im Wesentlichen durch die Verfahrensschritte gelöst:
- Herstellen eines Papiers enthaltend zumindest Cellulosefasern sowie zu carbonisierenden Füllstoff und/oder SiC, wobei als Füllstoff Ruß oder ein Gemisch aus Ruß und SiC oder ein Gemisch aus Ruß, SiC und Si verwendet wird,
- Pyrolysieren des hergestellten Papiers und
- Silizieren des pyrolysierten Papiers.

Erfindungsgemäß wird ein mit carbonisierendem Füllstoff wie Ruß beladenes Papier benutzt, so dass großflächige Keramiksubstrate hergestellt werden können. Abmessungen bis 1 x 1 m oder darüberliegend sind ohne Weiteres möglich. Gleichzeitig kann das Keramiksubstrat überaus dünn ausgebildet werden, so dass das Halbleiterbauelement ein geringes Gewicht aufweist. Neben Ruß und/oder zumindest einem anderen carbonisierenden bzw. carbonisierbaren Füllstoff kann SiC bzw. Si + SiC enthalten sein. Es besteht auch die Möglichkeit, das Papier allein mit SiC bzw. SiC + Si zu beladen. Zusätzlich kann das zu pyrolisierende Papier ein Bindemittel wie Phenolharz oder Cellulose enthalten. Unabhängig hiervon sollte der Gewichtsanteil des Füllstoffes 50 Gew.-% bis 85 Gew.-% bezogen auf die aus Cellulosefasern des Papiers und Füllstoff bestehende Trockensubstanz des Papiers betragen.

Die Silizierung selbst sollte mit Reinstsilizium erfolgen, wobei im Überschuss oder Unterschuss gearbeitet werden kann. Das Silizieren kann dabei mit üblichen Verfahren durchgeführt werden. Insbesondere wird jedoch das pyrolysierte Papier zum Silizieren mit einer Siliziumschmelze in Kontakt gebracht, z. B. durch Dochte, Transferplatten oder ähnliche Techniken.

In hervorzuhebender Ausgestaltung der Erfindung wird erwähntermaßen Silizium im Überschuss siliziert, wobei sich eine Siliziumschicht auf zumindest einer Flachseite des silizierten Keramiksubstrats ausbildet, auf die sodann die aktiven Schichten des Halbleiterbauelementes insbesondere epitaktisch z. B. durch CVD aufgetragen werden.

Das pyrolysierte Papier wird in einem Reaktionsraum vorzugsweise bei einem Druck siliziert, der im Bereich von 50 mbar bis 0,05 mbar, insbesondere im Bereich von 0,1 mbar liegen sollte. Nach der Reaktion des C mit dem Si zu SiC wird sodann der Reaktionsraum mit Inertgasatmosphäre belüftet, so dass überschüssiges Silizium nicht aus dem Reaktionsraum weggeführt wird, sondern sich auf dem silizierten Keramiksubstrat als Si-Schicht ausbilden kann. Dabei sollte der Prozess vorzugsweise derart gesteuert werden, dass die Si-Schicht eine Dicke d mit 0,5 µm ≤ d ≤ 50 µm, insbesondere 10 µm ≤ d ≤ 20 µm aufweist. Anschließend sollte die Si-Schicht kurz oberhalb des Schmelzpunktes des Silizium aufgeschmolzen und sodann rekristallisiert werden, um eine zu nutzende Keimschicht für die epitaktisch aufzutragenden aktiven Schichten des Halbleiterbauelementes, also insbesondere Si-Schichten gewünschter Dotierung vorzufinden.

Das Silizieren selbst sollte bei einer Temperatur T mit 1350 °C ≤ T ≤ 2000 °C, insbesondere im Bereich 1650 °C ≤ T ≤ 1700 °C durchgeführt werden.

Ein Keramiksubstrat in Form eines Trägers als Bestandteil eines Halbleiterbauelementes zeichnet sich dadurch aus, dass das Keramiksubstrat ein in SiC umgewandeltes ein mit carbonisierbarem Füllstoff und/oder SiC beladenes Papier ist, wobei auf zumindest einer Flachseite des Keramiksubstrats eine rekristallisierte Si-Schicht vorhanden ist, die bei der Herstellung des Keramiksubstrats mit ausgebildet wird.

Basis für den Träger ist demnach ein keramisches Papier.

Das SiC-Keramiksubstrat selbst sollte eine Dicke D mit D ≤ 2 mm, vorzugsweise D ≤ 0,8 mm aufweisen. Bevorzugterweise beläuft sich die Dicke D auf 0,5 mm ≤ D ≤ 1 mm.

Die auf zumindest einer Seite des Keramiksubstrats aufgebrachte Si-Schicht weist eine Dicke d mit 0,5 µm ≤ d ≤ 50 µm, insbesondere 10 µm ≤ d ≤ 20 µm auf.

Die Fläche F des Keramiksubstrats sollte insbesondere 1.600 cm² ≤ F ≤ 10.000 cm² oder mehr betragen.

Der Volumenanteil V des SiC in dem Papier selbst beträgt bevorzugterweise 25 Vol.-% ≤ V ≤ 85 Vol.-%, insbesondre 60 Vol.-% ≤ V ≤ 80 Vol.-%.

Die Erfindung zeichnet sich des Weiteren aus durch die Verwendung eines mit zu SiC reagierendem Füllstoff und/oder mit SiC gefüllten cellulosehaltigen Papiers zur Herstellung einer carbidischen Keramik als Substrat einer Solarzelle. Dabei ist insbesondere vorgesehen, dass der Anteil G des Füllstoffs beträgt 50 Gew.-% ≤ G ≤ 85 Gew.-%, bezogen auf die aus Cellulosefasern und Füllstoff bestehende Trockensubstanz des Papiers.

Der Füllstoff, der vorzugsweise Ruß ist oder enthält, kann des Weiteren oder alternativ SiC und Si im erforderlichen stöchiometrischen Verhältnis enthalten.

Neben dem Füllstoff können in das Papier weitere Additive wie Bindemittel beigegeben sein.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von Ausführungsbeispielen sowie zeichnerischen Darstellungen.

### Beispiel 1

Es wird eine Papierbahn mit einer Dicke von 0,7 mm, einem Gewicht von ca. 800 g/m² und einer Fläche von 1 m² benutzt, die mit einem aus Ruß bestehenden Füllstoff beladen ist. Der Gewichtsanteil des Füllstoffs beträgt ca. 75 % bezogen auf die aus Cellulosefasern und Füllstoff bestehende Trockensubstanz des Papiers. Das so beladene Papier wird sodann in inerter Atmosphäre bei einer Temperatur zwischen 800 °C und 1400 °C carbonisiert. Sodann erfolgt ein Silizieren des carbonisierten Papiers mittels eines Dochtes mit einer Siliziumschmelze, bei einer Temperatur im Bereich zwischen 1650 °C und 1700 °C. In dem Reaktionsraum selbst herrscht ein Druck im Bereich von 0,1 mbar. Das Silizieren erfolgt dabei mit Überschuss von Silizium. Nach erfolgter Reaktion des Siliziums mit Kohlenstoff zu SiC wird der Reaktionsraum mit Inertgas belüftet, um zu vermeiden, dass das überschüssige Silizium ausgetragen wird. Hierdurch bildet sich auf dem Keramiksubstrat eine Si-Schicht, wobei der Prozess derart gesteuert wird, dass die Dicke im Bereich zwischen 10 µm und 20 µm liegt. Die erstarrte Schicht wird sodann bei einer Temperatur kurz oberhalb des Schmelzpunktes von Silizium erneut aufgeschmolzen und rekristallisiert. Für das Silizieren selbst wird Reinstsilizium verwendet.

Es ergab sich eine dünnwandige hochstabile Struktur. Schliffbilder zeigen, dass das Substrat im Wesentlichen aus freies Silizium umgebendem SiC besteht. Nicht reagiertes C im verschwindenden Umfang kann enthalten sein.

Die Keramik kann als Substrat für eine Solarzelle eingesetzt werden. Dabei werden auf die rekristallisierte Si-Schicht die elektrisch aktiven Schichten der Solarzelle in üblicher Technik wie CVD epitaktisch aufgetragen. Die rekristallisierte Si-Schicht hat die Funktion einer Keimschicht.

### Beispiel 2

Es wird eine Papierbahn einer Dicke d mit d von 0,7 mm mit einem Gewicht von ca. 900 g/m² und einer Fläche von 1 m² benutzt, die mit einem aus Ruß und SiC bestehenden Füllstoff beladen ist. Der Gewichtsanteil des Füllstoffs beträgt ca. 75 % bezogen auf die aus Cellulosefasern und Füllstoff bestehende Trockensubstanz des Papiers. Das so beladene Papier wird sodann in inerter Atmosphäre bei einer Temperatur zwischen 800 °C und 1400 °C carbonisiert. Sodann erfolgt ein Silizieren des carbonisierten Papiers mittels eines Dochtes mit einer Siliziumschmelze, bei einer Temperatur im Bereich zwischen 1650 °C und 1700 °C. In dem Reaktionsraum selbst herrscht ein Druck im Bereich von 0,1 mbar. Das Silizieren erfolgt dabei mit einem Überschuss von Silizium. Nach erfolgter Reaktion des Siliziums mit Kohlenstoff zu SiC wird der Reaktionsraum mit Inertgas belüftet, um zu vermeiden, dass das überschüssige Silizium ausgetragen wird. Hierdurch bildet sich auf dem Keramiksubstrat eine Si-Schicht, wobei der Prozess derart gesteuert wird, dass die Dicke im Bereich zwischen 10 µm und 20 µm liegt. Die erstarrte Schicht wird sodann bei einer Temperatur kurz oberhalb des Schmelzpunktes von Silizium erneut aufgeschmolzen und rekristallisiert. Für das Silizieren selbst wird Reinstsilizium verwendet.

Es ergab sich eine dünnwandige hochstabile Struktur. Schliffbilder zeigen, dass das Substrat im Wesentlichen aus freies Silizium umgebendem SiC besteht. Nicht reagiertes C im verschwindenden Umfang kann enthalten sein.

Die Keramik kann als Substrat für eine Solarzelle eingesetzt werden. Dabei werden auf die rekristallisierte Si-Schicht die elektrisch aktiven Schichten der Solarzelle in üblicher Technik wie CVD epitaktisch aufgetragen. Die rekristallisierte Si-Schicht hat die Funktion einer Keimschicht.

### Beispiel 3

Es wird eine Papierbahn mit einer Dicke d mit d von 0,7 mm mit einem Gewicht von ca. 900 g/m² und einer Fläche von 1 m² benutzt, die mit einem aus Ruß und SiC bestehenden Füllstoff beladen ist. Der Gewichtsanteil des Füllstoffs beträgt ca. 75 % bezogen auf die aus Cellulosefasern und Füllstoff bestehende Trockensubstanz des Papiers. Das so beladene Papier wird sodann in inerter Atmosphäre bei einer Temperatur zwischen 800 °C und 1400 °C carbonisiert. Sodann erfolgt ein Silizieren des carbonisierten Papiers mittels eines Dochtes mit einer Siliziumschmelze, bei einer Temperatur im Bereich zwischen 1650 °C und 1700 °C. In dem Reaktionsraum selbst herrscht ein Druck im Bereich von 0,1 mbar. Das Silizieren erfolgt mit einem Unterschuss an Silizium, um ein Keramikbauteil herzustellen, das aufgrund verbleibenden Restkohlenstoffs bzw. Restporosität ein geringeres Gewicht hat. Nach erfolgter Kapillarsilizierung wird der verbleibende Si-Dampfdruck in der Silizieranlage genutzt, um Si aus Dampfphase auf der Substratoberfläche abzuscheiden. Danach wird mit Inert gas belüftet, wobei der Prozess derart gesteuert wird, dass die Dicke der Si-Schicht im Bereich 10 µm bis 20 µm liegt. Die erstarrte Schicht wird sodann bei einer Temperatur kurz oberhalb des Schmelzpunktes von Silizium erneut aufgeschmolzen und rekristallisiert. Für das Silizieren selbst wird Reinstsilizium verwendet.

Es ergab sich eine dünnwandige hochstabile Struktur. Schliffbilder zeigen, dass das Substrat im Wesentlichen aus freies Silizium umgebendem SiC besteht. Nicht reagiertes C im verschwindenden Umfang kann enthalten sein.

Die Keramik kann als Substrat für eine Solarzelle eingesetzt werden. Dabei werden auf die rekristallisierte Si-Schicht die elektrisch aktiven Schichten der Solarzelle in üblicher Technik wie CVD epitaktisch aufgetragen. Die rekristallisierte Si-Schicht hat die Funktion einer Keimschicht.

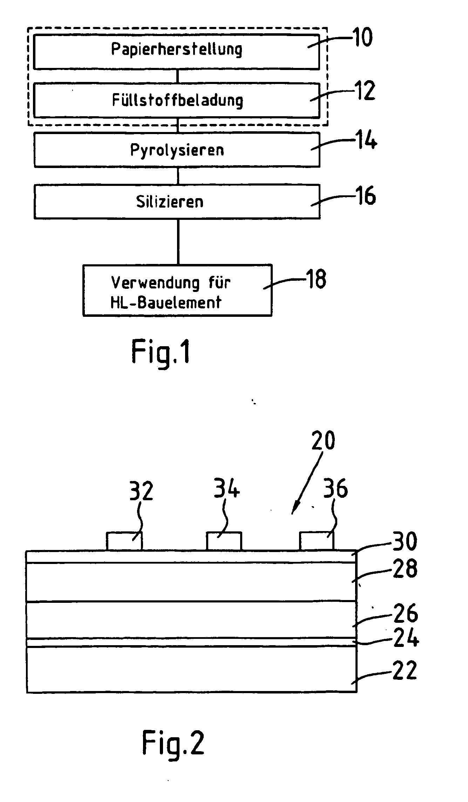

Anhand der Fig. 1 soll noch einmal das erfindungsgemäße Verfahren erläutert werden. Um ein Keramiksubstrat für ein Halbleiterbauelement herzustellen, das großflächig ausgebildet ist und ein geringes Gewicht aufweist, wird zunächst Papier hergestellt und mit Füllstoff wie Russ und SiC beladen. Dabei können die Papierherstellung und die Füllstoffbeladung in einem Verfahrensablauf erfolgen, wie die gestrichelte Umrandung der Verfahrensschritte Papierherstellung 10 und Füllstoffbeladung 12 symbolisiert. Anschließend wird das mit dem Füllstoff beladene Papier pyrolysiert, wobei bei einer Temperatur vorzugsweise im Bereich zwischen 800 °C und 1400 °C ein Carbonisieren erfolgt (Verfahrensschritt 14). Sodann erfolgt ein Silizieren (Verfahrensschritt 16). Dies kann mittels eines Dochtes mit einer Siliziumschmelze bei einer Temperatur im Bereich zwischen 1650 °C und 1700 °C in einem Reaktionsraum erfolgen, in dem ein Druck von 0,1 mbar herrscht. Das Silizieren sollte dabei mit einem Überschuss an Silizium erfolgen. Dabei kann nach erfolgter Reaktion des Siliziums mit Kohlenstoff zu SiC der Reaktionsraum mit Inertgas belüftet werden, um zu vermeiden, dass überschüssiges Silizium ausgetragen wird. Hierdurch wird erreicht, dass sich auf dem so hergestellten Keramiksubstrat eine Si-Schicht ausbildet, wobei in Abhängigkeit von der Prozesssteuerung Dicken zwischen 10 µm und 20 µm erreicht werden. Ein entsprechendes eine Siliziumschicht aufweisendes Keramiksubstrat kann sodann als Träger für ein Halbleiterbauelement verwendet werden (Verfahrensschritt 18). Als Halbleiterbauelement ist insbesondere eine Solarzelle vorgesehen, die rein prinzipiell der Fig. 2 zu entnehmen ist.

Die Solarzelle 20 weist einen Träger bzw. ein Substrat 22 in Form der erfindungsgemäß hergestellten Keramik auf, wobei die den photoaktiven Schichten zugewandte Fläche eine Si-Schicht 24 im Bereich zwischen 10 µm und 20 µm aufweist. Die Dicke des Trägers 22 ist derart, dass die Zelle formstabil ist.

Die Siliziumschicht 24 kann als Keimschicht dienen, auf die epitaktisch eine z. B. p-leitende SiC-Schicht 26 mit einer Dicke im Bereich zwischen 20 µm und 100 µm aufgetragen wird, die als Rückseitenkontakt dient. Auf die SiC-Schicht 26 werden sodann die photoaktiven Epitaxie-Schichten 28, 30 in Form einer p-leitenden Schicht und in Form einer n-leitenden Schicht aufgetragen. Schließlich werden auf die n-leitende Schicht 30 vorzugsweise streifenförmige Frontkontakte 32, 34, 36 aufgebracht.

Die in Fig. 2 dargestellte Solarzelle 20 ist rein prinzipiell in ihrem Aufbau zu verstehen, wobei auch anstelle eines np-Aufbaus ein pn-Aufbau gegeben sein kann.

Aufgrund der erfindungsgemäßen Lehre können großflächige Solarzellen hinreichender Stabilität hergestellt werden, die Flächen einer Größe von 1 m² oder mehr aufweisen.

## Patentansprüche

1. Verfahren zur Herstellung eines Keramiksubstrats eines Halbleiterbauelementes **gekennzeichnet durch** die Verfahrensschritte
- Herstellen eines Papiers enthaltend zumindest Cellulosefasern sowie zu carbonisierenden Füllstoff und/oder SiC, wobei als Füllstoff Ruß oder ein Gemisch aus Ruß und SiC oder ein Gemisch aus Ruß, SiC und Si verwendet wird,
- Pyrolysieren des hergestellten Papiers und
- Silizieren des pyrolysierten Papiers.

2. Verfahren nach Anspruch 1,
**dadurch gekennzeichnet,**
**dass** als Additiv für das zu pyrolysierende Papier Bindemittel wie Phenolharz oder Cellulose beigegeben wird.

3. Verfahren nach zumindest einem der vorhergehenden Ansprüche,
**dadurch gekennzeichnet,**
**dass** Füllstoff mit einem Gewichtsanteil G mit 50 Gew.-% ≤ G ≤ 85 Gew.-%, insbesondere 60 Gew.-% ≤ G ≤ 80 Gew.-%, bezogen auf die aus Cellulosefasern und Füllstoff bestehende Trockensubstanz des Papiers in das Papier eingebracht wird.

4. Verfahren nach zumindest einem der vorhergehenden Ansprüche,
**dadurch gekennzeichnet,**
**dass** das pyrolisierte Papier mit Reinstsilizium siliziert wird, insbesondere mit Reinstsilizium im Überschuss oder Unterschuss siliziert wird.

5. Verfahren nach zumindest einem der vorhergehenden Ansprüche,
**dadurch gekennzeichnet,**
**dass** das pyrolisierte Papier mittels einer Siliziumschmelze siliziert wird.

6. Verfahren nach zumindest einem der vorhergehenden Ansprüche,
**dadurch gekennzeichnet,**
**dass** überschüssiges Silizium als Siliziumschicht auf zumindest einer Flachseite des silizierten Keramiksubstrats ausgebildet wird.

7. Verfahren nach zumindest einem der vorhergehenden Ansprüche,
**dadurch gekennzeichnet,**
**dass** das pyrolisierte Papier in einem Reaktionsraum bei einem Druck p mit 50 mbar ≤ p ≤ 0,05 mbar, vorzugsweise p ≈ 0,1 mbar siliziert wird.

8. Verfahren nach zumindest einem der vorhergehenden Ansprüche,
**dadurch gekennzeichnet,**
**dass** die Ausbildung der Si-Schicht vor, während oder nach Belüften des Reaktionsraums bei Inertgasatmosphäre durchgeführt wird.

9. Verfahren nach zumindest einem der vorhergehenden Ansprüche,
**dadurch gekennzeichnet,**
**dass** die Reaktion des carbonisierten Papiers mit Si zu SiC bei einer Temperatur T mit 1350 °C ≤ T ≤ 2000 °C, vorzugsweise mit 1650 °C ≤ T ≤ 1700 °C durchgeführt wird.

10. Verfahren nach zumindest einem der vorhergehenden Ansprüche,
**dadurch gekennzeichnet,**
**dass** nach Ausbilden der Si-Schicht diese aufgeschmolzen und zur Rekristallisation abgekühlt wird.

11. Verfahren nach zumindest einem der vorhergehenden Ansprüche,
**dadurch gekennzeichnet,**
**dass** auf die rekristallisierte Si-Schicht epitaktisch Schichten des Halbleiterbauelementes aufgetragen werden.

12. Keramiksubstrat in Form eines Trägers als Bestandteil eines Halbleiterbauelementes,
**dadurch gekennzeichnet,**
**dass** das Keramiksubstrat ein in SiC umgewandeltes und mit einem carbonisierbarem Füllstoff und/oder SiC beladenes Papier ist und auf zumindest einer Flachseite eine rekristallisierte Si-Schicht aufweist.

13. Keramiksubstrat nach Anspruch 12,
**dadurch gekennzeichnet,**
**dass** das Keramiksubstrat eine Dicke D mit D ≤ 2,0 mm, vorzugsweise D ≤ 0,8 mm, insbesondere eine Dicke D mit 0,5 mm ≤ D ≤ 1 mm aufweist und/oder dass das Keramiksubstrat eine Fläche F mit 1.600 cm² ≤ F ≤ 10.000 cm² aufweist.

14. Keramiksubstrat nach Anspruch 12,
**dadurch gekennzeichnet,**
**dass** die Si-Schicht eine Dicke d mit 0,5 µm ≤ d ≤ 50 µm, insbesondere 10 µm ≤ d ≤ 20 µm aufweist.

15. Keramiksubstrat nach Anspruch 12,
**dadurch gekennzeichnet,**
**dass** der Anteil des Füllstoffes 50 Gew.-% bis 85 Gew.-%, insbesondere 60 Gew.-% bis 80 Gew.-% beträgt, bezogen auf die aus Cellulosefasern und Füllstoff bestehende Trockensubstanz des Papiers.

16. Verwendung eines mit zu SiC reagierendem Füllstoff und/oder SiC befüllten cellulosehaltigen Papiers zur Herstellung einer carbidischen Keramik als Substrat einer Solarzelle.

17. Verwendung nach Anspruch 16,
**dadurch gekennzeichnet,**
**dass** der Anteil G des Füllstoffs beträgt 50 Gew.-% ≤ G ≤ 85 Gew.-% bezogen auf die aus Cellulosefasern und Füllstoff bestehende Trockensubstanz des Papiers, wobei gegebenenfalls neben dem Füllstoff ein Bindemittel dem herzustellenden Papier beigegeben ist.

18. Verwendung nach Anspruch 16,
**dadurch gekennzeichnet,**
**dass** das Papier eine Fläche F mit 0,16 m² ≤ F ≤ 1 m² und/oder das Papier eine Dicke D mit 0,5 mm ≤ D ≤ 1 mm aufweist.

## Claims

1. Method for the production of a ceramic substrate of a semiconductor component, **characterized by** the process steps
- Production of a paper containing at least cellulose fibers, as well as a filler to be carbonized, and/or SiC, whereby carbon black or a mixture of carbon black and SiC or a mixture of carbon black, SiC, and Si is used as filler,
- Pyrolysis of the produced paper, and
- Silizonizing of the pyrolyzed paper.

2. Method according to claim 1,
**characterized in**
**that** a binder such as phenolic resin or cellulose is added as an additive for the paper to be pyrolyzed.

3. Method according to at least one of the preceding claims,
**characterized in**
**that** filler with a percentage by weight G of 50% by weight ≤ G ≤ 85% by weight, particularly 60% by weight ≤ G ≤ 80% by weight, based on the paper dry matter consisting of cellulose fibers and filler, is introduced into the paper.

4. Method according to at least one of the preceding claims,
**characterized in**
**that** the pyrolyzed paper is siliconized with high-purity silicon, especially is siliconized with high-purity silicon in an excess or deficient amount.

5. Method according to at least one of the preceding claims,
**characterized in**
**that** the pyrolyzed paper is siliconized with a silicon melt.

6. Method according to at least one of the preceding claims,
**characterized in**
**that** excess silicon is formed as silicon layer on at least one flat side of the siliconized ceramic substrate.

7. Method according to at least one of the preceding claims,
**characterized in**
**that** the pyrolyzed paper is siliconized in a reaction chamber at a pressure p of 50 mbar ≤ p ≤ 0.05 mbar, preferably p ≈ 0.1 mbar.

8. Method according to at least one of the preceding claims,
**characterized in**
**that** the formation of the Si layer is carried out before, during, or after aeration of the reaction chamber in an inert gas atmosphere.

9. Method according to at least one of the preceding claims,
**characterized in**
**that** the reaction of the carbonized paper with Si to SiC is carried out at a temperature T of 1350 °C ≤ T ≤ 2000 °C, preferably at 1650 °C ≤ T ≤ 1700 °C.

10. Method according to at least one of the preceding claims,
**characterized in**
**that** after formation of the Si layer, said layer is melted and cooled for recrystallization.

11. Method according to at least one of the preceding claims,
**characterized in**
**that** layers of the semiconductor component are applied epitaxially onto the recrystallized Si layer.

12. Ceramic substrate in form of a support as part of a semiconductor component,
**characterized in**
**that** the ceramic substrate is a paper converted to SiC and loaded with a carbonizable filler and/or SiC and has a recrystallized Si layer on at least one flat side.

13. Ceramic substrate according to claim 12,
**characterized in**
**that** the ceramic substrate has a thickness D ≤ 2.0 mm, preferably D ≤ 0.8 mm, especially a thickness D of 0.5 mm ≤ D ≤ 1 mm and/or that the ceramic substrate has an area F of 1600 cm² ≤ F ≤ 10,000 cm².

14. Ceramic substrate according to claim 12,
**characterized in**
the Si layer has a thickness d of 0.5 µm ≤ d ≤ 50 µm, particularly 10 µm ≤ d ≤ 20 µm.

15. Ceramic substrate according to claim 12,
**characterized in**
**that** the proportion of the filler is 50% by weight to 85% by weight, particularly 60% by weight to 80% by weight, based on the paper dry matter consisting of cellulose fibers and filler.

16. Use of a cellulose-containing paper, filled with a filler reacting to form SiC and/or with SiC, for the production of a carbide ceramic as a substrate of a solar cell.

17. Use according to claim 16,
**characterized in**
**that** the proportion G of the filler is 50% by weight ≤ G ≤ 85% by weight, based on the paper dry matter consisting of cellulose fibers and filler, where when required a binder is added to the paper to be made in addition to the filler.

18. Use according to claim 16,
**characterized in**
**that** the paper has an area F of 0.16 m² ≤ F ≤ 1 m² and/or the paper has a thickness D of 0.5 mm ≤ D ≤ 1 mm.

## Revendications

1. Procédé pour fabriquer un substrat en céramique d'un composant semi-conducteur **caractérisé par** les étapes
- fabrication d'un papier contenant au moins des fibres de cellulose ainsi qu'une matière de charge à carboniser et/ou du SiC, sachant que comme matière de charge est utilisé du noir de carbone ou un mélange de noir de carbone et de SiC, ou un mélange de noir de carbone, de SiC et de Si,
- pyrolyse du papier fabriqué et
- silication du papier pyrolysé.

2. Procédé selon la revendication 1,
**caractérisé en ce**
**que** comme additif pour le papier à pyrolyser est ajouté un liant tel que de la résine phénolique ou de la cellulose.

3. Procédé selon au moins l'une des revendications précédentes,
**caractérisé en ce**
**que** la matière de charge est incorporée dans le papier avec une part en poids G telle que 50 % en poids ≤ G ≤ 85 % en poids, en particulier 60 % en poids ≤ G ≤ 80 % en poids, rapportée à la matière sèche du papier constituée de fibres de cellulose et de la matière de charge.

4. Procédé selon au moins l'une des revendications précédentes,
**caractérisé en ce**
**que** le papier pyrolysé est silicé avec du silicium extra-pur, en particulier avec du silicium extra-pur en quantité excédentaire ou déficitaire.

5. Procédé selon au moins l'une des revendications précédentes,
**caractérisé en ce**
**que** le papier pyrolysé est silicé au moyen d'une fonte de silicium.

6. Procédé selon au moins l'une des revendications précédentes,
**caractérisé en ce**
**que** le silicium excédentaire est formé comme couche de silicium sur au moins une face plane du substrat en céramique silicé.

7. Procédé selon au moins l'une des revendications précédentes,
**caractérisé en ce**
**que** le papier pyrolysé est silicé dans un espace de réaction sous une pression p telle que 50 mbar ≤ p ≤ 0,05 mbar, de préférence p ≈ 0,1 mbar.

8. Procédé selon au moins l'une des revendications précédentes,
**caractérisé en ce**
**que** la formation de la couche de Si est effectuée avant, pendant ou après ventilation de l'espace de réaction sous une atmosphère inerte.

9. Procédé selon au moins l'une des revendications précédentes,
**caractérisé en ce**
**que** la réaction du papier carbonisé avec le Si pour former du SiC est effectuée sous une température telle que 1350 °C ≤ T ≤ 2000 °C, de préférence telle que 1650 °C ≤ T ≤ 1700 °C.

10. Procédé selon au moins l'une des revendications précédentes,
**caractérisé en ce**
**qu'**après la formation de la couche de Si, celle-ci est fondue puis refroidie pour recristallisation.

11. Procédé selon au moins l'une des revendications précédentes,
**caractérisé en ce**
**que** des couches épitaxiales du composant semi-conducteur sont appliquées sur la couche de Si recristallisée.

12. Substrat en céramique sous forme de support en tant qu'élément constitutif d'un composant semi-conducteur,
**caractérisé en ce**
**que** le substrat en céramique est un papier transformé en SiC et chargé d'une matière de charge carbonisable et/ou de SiC, et présente une couche de Si recristallisée sur au moins une face plane.

13. Substrat en céramique selon la revendication 12,
**caractérisé en ce**
**que** le substrat en céramique présente une épaisseur D telles que D ≤ 2,0 mm, de préférence D ≤ 0,8 mm, en particulier une épaisseur D telle que 0,5 mm ≤ D ≤ 1 mm, et/ou que le substrat en céramique présente une surface F telle que 1 600 cm² ≤ F ≤ 10 000 cm².

14. Substrat en céramique selon la revendication 12,
**caractérisé en ce**
**que** la couche de Si présente une épaisseur d telle que 0,5 µm ≤ d ≤ 50 µm, en particulier 10 µm ≤ d ≤ 20 µm.

15. Substrat en céramique selon la revendication 12,
**caractérisé en ce**
**que** la part de la matière de charge est comprise entre 50 % en poids et 85 % en poids, en particulier entre 60 % en poids et 80 % en poids, rapportée à la matière sèche du papier constituée de fibres de cellulose et de la matière de charge.

16. Mise en oeuvre d'un papier cellulosique chargé d'une matière de charge réagissant pour former du SiC et/ou de SiC, pour fabriquer une céramique au carbure comme substrat d'une cellule solaire

17. Mise en oeuvre selon la revendication 16,
**caractérisée en ce**
**que** la part G de la matière de charge est telle que 50 % en poids ≤ G ≤ 85 % en poids, rapportée à la matière sèche du papier constituée de fibres de cellulose et de la matière de charge, sachant qu'en plus de la matière de charge, un liant est le cas échéant ajouté au papier à fabriquer.

18. Mise en oeuvre selon la revendication 16,
**caractérisée en ce**
**que** le papier présente une surface F telle que 0,16 m² ≤ F ≤ 1 m² et/ou une épaisseur D telle que 0,5 mm ≤ D ≤ 1 mm.
